# EUROPÄISCHE PATENTSCHRIFT

(11) **EP 3 176 055 B1**
(45) Veröffentlichungstag und Bekanntmachung des Hinweises auf die Patenterteilung: **22.05.2019**
(21) Anmeldenummer: 16002341.2
(22) Anmeldetag: 03.11.2016
(51) Int. Cl.: B62D 1/06

(54) **LENKRADUMMANTELUNG**
STEERING WHEEL COVER
COUVRE-VOLANT

(30) Priorität: 16.11.2015 DE 202015007837 U
(43) Veröffentlichungstag der Anmeldung: 07.06.2017
(60) Teilanmeldung: 18000421.0
(73) Patentinhaber: I.G. Bauerhin GmbH, 63584 Gründau (DE)
(72) Erfinder: Michelmann, Jochen, D-63571 Geinhausen (DE); Flittner, Klaus, D-63867 Johannesberg (DE); Müller, Martin, D-63628 Bad Soden-Salmünster (DE)
(74) Vertreter: Grimm, Ekkehard

(56) Entgegenhaltungen:
- DE-A1-102006 036 405
- DE-A1-102009 058 138
- DE-A1-102011 084 903
- US-A1- 2014 175 078

## Beschreibung

Die vorliegende Erfindung betrifft eine Lenkradummantelung gemäß dem Oberbegriff des Anspruchs 1. Diese Lenkradummantelungen werden aufgrund ihres Aufbaus als Teil einer Anordnung eingesetzt, mit der erfasst wird, ob sich eine Hand des Fahrers an dem Lenkrad befindet, indem über eine Auswerteeinheit die Impedanz zwischen einer Elektrode innerhalb der Lenkradummantelung und der Fahrzeugkarosserie bestimmt wird.

Eine solche Lenkradummantelung besitzt einen mehrschichtigen Aufbau, der in der Abwicklung in einer Ebene eine Umfangslänge und eine Querschnittsbreite aufweist. Die Umfangslänge ist dem Außenumfang eines mit der Lenkradummantelung zu beziehenden Lenkradkranzes zugeordnet und die Querschnittsbreite ist dem Außendurchmesser, in Querschnittsrichtung des Lenkradkranzes gesehen, zugeordnet. Die Lenkradummantelung ist von einem mehrschichtigen Aufbau, wobei sich die Schichten, zumindest teilweise, in Projektion aufeinander, überdecken.

Die Schichtfolge umfasst eine untere, zu dem Lenkradkern hin weisende, elektrisch leitfähige Abschirmschicht, gefolgt, in Richtung zu einer oberen, dem äußeren Lenkradbezug zugeordneten Decklage gesehen, von einer Isolationsschicht und mindestens einer elektrisch leitfähigen Sensorschicht.

Die Abschirmschicht und/oder die Sensorschicht besitzen eine Leiterstruktur mit in Umfangslänge und in Querschnittsbreite verlaufenden Leitern; die Abschirmschicht und die Sensorschicht sind mit Anschlussleitern eines Anschlusskabels elektrisch verbunden.

Die DE 203 09 603 U1 beschreibt eine Lenkeinrichtung, d. h. ein Lenkrad für ein Kraftfahrzeug. Das Lenkrad besitzt eine Sensoreinrichtung, die als kapazitives Sensorelement ausgeführt ist, die im Bereich des Lenkradkranzes des Lenkrads angeordnet ist. Diese Sensoreinrichtung dient dazu, die Annäherung und/oder einen Kontakt des Lenkradkranzes durch eine Hand eines Fahrers durch Änderung der Kapazität des Sensorelements zu erfassen, um auch zu ermitteln, ob sich die Hand eines Fahrzeuginsassen vollständig oder nur teilweise an dem Lenkrad oder sich auch nur in der Nähe des Lenkrads befindet und ob das Lenkrad mit der vollständigen Hand umfasst oder nur durch einzelne Finger berührt wird. Die Sensoreinrichtung ist durch einen Lenkradbezug oder eine Lenkradverkleidung aus einem Leder- oder Kunststoffmaterial abgedeckt und aus einer Leiteranordnung aufgebaut, die beispielsweise als um den Lenkradkranz herumgewickelten elektrisch leitenden Draht ausgeführt ist. Diese Leiteranordnung wirkt als kapazitive Sensoreinrichtung. Die Signale werden durch eine Auswerteelektronik erfasst, die im zentralen Lenkradbereich angeordnet sein kann. Die Sensoreinrichtung kann auch durch eine leitende Netzstruktur oder durch Flachbandleiter aufgebaut werden. In einer Ausführungsform ist der Lenkradkranz in Abschnitte unterteilt, um eine ortsaufgelöste Detektion zu ermöglichen. Es ist auch vorgesehen, dass die Leiteranordnung zugleich als Heizeinrichtung dient.

Die DE 10 2009 058 138 A1 beschreibt ein Verfahren zur Herstellung eines Näherungssensors für ein Fahrzeug, der für ein Lenkrad in einem Fahrzeug vorgesehen ist. Dieser Näherungssensor besitzt eine obere Gewebelage, in die leitfähige Kettfäden eingearbeitet sind, eine untere Gewebelage, in die leitfähige Schussfäden eingearbeitet sind, und eine mittlere Gewebelage aus nichtleitenden Fäden, die die obere und die untere Gewebelage gegeneinander isoliert. Die obere und die untere Gewebelage sind jeweils über einen Anschluss mit einer Auswerteeinheit verbunden. Die Gesamtkapazität dieser Anordnung setzt sich aus der Kapazität der drei Gewebelagen sowie einer Kapazität, die sich mit dem Abstand eines Fingers oder einer Hand von der Anordnung ändert, zusammen.

Die DE 10 2011 084 903 A1 ist auf Sensorsysteme für ein Kraftfahrzeug, auch zum Einbau in ein Lenkrad, das zusätzlich eine Heizeinrichtung aufweist, gerichtet, mit kapazitivem Sensorelement, das eine Störbeeinflussung durch parasitäre Kapazitäten vermeiden oder minimieren soll. Bei der Anordnung dieses Sensorelements an dem Lenkradkranz eines Lenkrads, das zusätzlich beheizbar ist, wobei der Lenkradkranz aus einem Metallskelett, das von einem Dielektrikum umgeben ist, aufgebaut ist, befindet sich auf dem Dielektrikum eine Heizschicht, die auf der Außenseite von einer Abschirmschicht abgedeckt ist, gefolgt durch eine Sensorschicht, die ihrerseits durch einen Bezug des Lenkrads umhüllt ist. Ein Heizleiter des Heizleiters und/oder ein Sensorleiter des kapazitiven Sensorelements können als Nähfäden ausgebildet sein. Für die Abschirmschicht kann ein Metallgewebe, das durch Kettdrähte und Schussdrähte gebildet ist, eingesetzt werden. Die DE 10 2011 084 903 offenbart den Oberbegriff des Anspruchs 1.

Ein weiteres Sensorsystem für ein Lenkrad eines Fahrzeugs ist in der US 2012/0326735 A1 beschrieben und weist einen ersten Sensor auf, der innerhalb eines linken, vorderen Bereichs des Lenkrads angeordnet ist, um einen Kontakt des linken, vorderen Teils des Lenkrads zu erfassen, und weist einen zweiten Sensor auf, der innerhalb eines rechten, vorderen Bereichs des Lenkrads angeordnet ist, um einen Kontakt des rechten, vorderen Teils des Lenkrads, getrennt von dem ersten Bereich, zu erfassen. Weiterhin ist ein dritter Sensor vorgesehen, der der Rückseite des Lenkrads zugeordnet ist, um eine Berührung des rückseitigen Bereichs des Lenkrads zu erfassen. Über die drei Sensoren kann ein Berühren des jeweiligen Bereichs, die den Sensoren zugeordnet sind, mit der Hand eines Fahrers erfasst werden, wobei auch eine Berührung durch den Fahrer, die nicht mit der Hand erfolgt, unterschieden werden soll. Als Sensor können komplexe Impedanz-Sensoren eingesetzt werden.

Die DE 203 09 877 U1 ist auf ein Fahrzeugsicherheitssystem gerichtet, bei dem in dem Lenkradkranz eines Lenkrads wenigstens ein kapazitiver Sensor, vorzugsweise mehrere Sensoren, integriert sind. Über die Sensoren wird eine Veränderung eines elektrischen oder elektromagnetischen Felds erfasst. Die Sensoren liegen zwischen der Umhüllung, beispielsweise aus einer PUR-Umschäumung, eines Lenkradskeletts und einer den Lenkradkranz nach außen abschließenden Umhüllung in Form einer flexiblen Schaumschicht, einer Leder- oder Holzumhüllung. Es ist auch vorgesehen, dass die Sensoren durch wenigstens einen Abschnitt einer Lenkradheizung gebildet sind. Bei dem Einsatz von mehreren Sensoren können Rückschlüsse auf die Position des Oberkörpers oder des Kopfs eines Fahrers relativ zur Drehachse des Lenkrads gezogen werden. Die Sensoren können als eine flexible Matte mit darin aufgenommenen, langgestreckten elektrischen Leitern aufgebaut sein. Auch kann ein solcher Sensor eine Vliesmatte enthalten.

Der vorliegenden Erfindung liegt die Aufgabe zugrunde, eine Lenkradummantelung mit einer Sensoranordnung anzugeben, die durch ihren Aufbau und/oder durch das verwendete Material für deren Anordnung an einem Lenkrad besonders gut geeignet sind.

Gelöst wird diese Aufgabe durch eine Lenkradummantelung mit den Merkmalen des Anspruchs 1. Bevorzugte Ausgestaltungen dieser Lenkradummantelungen sind in den abhängigen Ansprüchen angegeben.

Die Lenkradummantelung der Erfindung ist dadurch gekennzeichnet, dass die elektrische Verbindung des jeweiligen Anschlussleiters des Anschlusskabels mit der Abschirmschicht und/oder der Sensorschicht über jeweils eine Metallfolie gebildet ist. Durch die Verwendung einer Metallfolie, im Bereich derer eine elektrische Verbindung eines Anschlusskabels mit der jeweiligen Abschirmschicht oder Sensorschicht vorgenommen wird, ist eine elektrische Kontaktierung dieser Schichten sichergestellt. Trotz des dadurch erzielbaren flächigen Kontaktierungsbereichs trägt die Metallfolie unter dem Bezug des Lenkrads, insbesondere des Lenkradkranzes, nicht auf und zeichnet sich dadurch nicht durch den Lenkradbezug auf dessen Außenseite ab. Bevorzugter Weise wird der Kontaktierungsbereich mit der Metallfolie im Speichenbereich des Lenkrads angeordnet. Auch für die Montage dieser Lenkradummantelung an einem Lenkradkranz zeichnet sich die Metallfolie durch deren Nachgiebigkeit aus, um sie der Rundung des Lenkradkranzes anzupassen. Die Größe dieser Metallfolie wird vorzugsweise so gewählt, dass deren Länge und/oder Breite mindestens dem dreifachen Abstand der benachbarten, nicht leitenden Kettfäden entspricht.

Die Abschirmschicht und/oder die Sensorschicht kann eine gewirkte Struktur mit nicht leitenden, maschenbildenden Kettfäden und mit leitenden Schussfäden aufweisen. Die Schussfäden sollten dann zumindest ein leitendes Material enthalten. Auch dieser Aufbau der Lenkradummantelung bringt den Vorteil mit sich, dass er sich an jeder Stelle dem Lenkradkranz, auf den er aufgebracht wird, anpassen kann, insbesondere im Hinblick darauf, dass er durch die gewirkte Struktur der Abschirmschicht und/oder der Sensorschicht ein gutes Dehnverhalten sowohl in der Umfangslänge als auch in der Querschnittsbreite, in der Abwicklung gesehen, und damit in Umfangsrichtung des Lenkradkranzes als auch in Richtung des Querschnitts des Lenkradkranzes gesehen, besitzt.

In einer Ausführungsform überdeckt die Metallfolie mehrere Leiter der jeweiligen Leiterstruktur der Abschirmschicht oder der Sensorschicht, wobei auch hier bevorzugt die Länge oder die Breite der Metallfolie mindestens dem dreifachen Abstand der benachbarten, nicht leitenden Kettfäden entspricht. Die Abmessungen der Metallfolie können auch in Bezug auf deren Länge und/oder deren Breite an einem Stichabstand von Stichen bemessen werden, mit denen leitfähige Fäden in der Abschirmschicht und/oder der Sensorschicht an einem Trägermaterial gehalten werden; die jeweilige Abmessung beträgt dann mindestens den fünffachen Stichabstand des leitfähigen Fadens.

Auch ist vorgesehen, dass die Metallfolie mittels elektrisch leitfähigem Klebemittel mit den Leitern der jeweiligen Leiterstruktur verbunden ist. Ein solches leitfähiges Klebemittel dringt in die Struktur der Abschirmschicht oder der Sensorschicht ein und erzielt zusätzliche Kontaktbereiche zwischen den elektrisch leitenden Leitern der Leiterstruktur.

Für eine gute Zugänglichkeit des Anschlussbereichs der Abschirmschicht und/oder der Sensorschicht sind diese in dem Bereich, an dem sie mit den Anschlussleitern des Anschlusskabels verbunden sind, so verlängert, dass sie die Form einer Lasche aufweisen. Diese Lasche kann in der um den Lenkradkern herumgezogenen Lenkradummantelung so positioniert werden, dass sie im Bereich einer Speiche des Lenkrads zu dem Bereich der Lenkradnabe hin orientiert oder geführt werden kann. Die Lasche kann in einer rechteckigen Form ausgeführt werden. Es ist aber auch vorgesehen, die Lasche mit einer trapezförmigen Außenkontur oder einer ovalen Außenkontur auszuführen, so dass sie zu ihrem freien Ende hin schmaler wird. Die Lasche kann ein Verhältnis von Länge zu Breite von 10:1 bis 1:10 haben; bevorzugt besitzt die Lasche nur eine kleine Länge, jedoch eine große Breite, entlang derer sie mit der Hauptfläche verbunden ist, so dass ein Verhältnis von Länge zu Breite von 1:10 bis 2:5 eingehalten werden sollte.

Das Anschlusskabel kann als Koaxialkabel mit einem Innenleiter und einem koaxialen Kabelschirm und einem äußeren Schutzmantel ausgebildet werden. Bei diesem Koaxialkabel bildet der Innenleiter den mit der Sensorschicht verbunden Anschlussleiter und der Kabelschirm bildet den mit der Abschirmschicht verbundenen Anschlussleiter. Durch das Koaxialkabel werden äußere Störeinflüsse, die auf die Anschlussleiter umgebungsbedingt einwirken können, vermieden oder zumindest weitestgehend unterdrückt.

Die Abschirmschicht und/oder die Sensorschicht können aus einem leitfähigen Textil gebildet werden, das sich den Gegebenheiten, d.h. beispielsweise der Form des Lenkradkerns, anpassen. Ein solches leitfähiges Textil kann metallisierte, textile Fasern aufweisen. Vorgesehen sind hierbei Fasern aus versilbertem PA66 Garn, mit einem Widerstand von kleiner 500 Ohm/m. Ebenso sind auch Fasern mit einem Widerstand kleiner 1000 Ohm/m möglich. In einer weiteren Ausführungsform kann das leitfähige Textil Drähte aus Metall und/oder Metalllegierung als leitfähige Fasern enthalten.

Die Sensorschicht und die Abschirmschicht mit der dazwischen liegenden Isolationsschicht werden so dimensioniert und zueinander beabstandet, dass sie einen Kondensator mit einer Kapazität von mindestens 100 pF bilden. Die Isolationsschicht sollte so ausgebildet sein, dass die Sensorschicht über der Abschirmschicht liegt und nicht in diese eindringt, um so eine komplette Abschirmung des Lenkradkranzes zu erreichen.

Damit die Sensorschicht vollständig gegenüber äußeren Einflüssen abgeschirmt wird, wird die Sensorschicht so bemessen, dass sie in ihrer Fläche kleiner als die Abschirmschicht ist. Hierbei sollte die Sensorschicht in Projektion auf die Abschirmschicht zumindest auf einer Seite, in Querschnittsbreite gesehen, d.h. in Richtung des Querschnittumfangs des Lenkradkranzes, kleiner als die Abschirmschicht sein.

Damit das textile Material besonders gut für die Ummantelung und den vorgesehenen Einsatz geeignet ist, wird dieses derart aufgebaut, dass sich Schussfäden des textilen Materials zwischen Kettfäden des textilen Materials erstrecken, und zwar so, dass jeder Schussfaden mit mindestens dem nächsten benachbarten Schussfaden in einer elektrischen Verbindung steht. Ein solches Material zeichnet sich durch sein besonders gutes Dehnverhalten und einen geringen Materialeinsatz aus.

Bei einem anderen textilen Material, das für bestimmte Anwendungszwecke als bevorzugt anzusehen ist, verlaufen zwischen benachbarten und zueinander beabstandeten, nicht leitenden Kettfäden die leitenden Schussfäden. Hierbei können die Kettfäden in Trikottechnik oder in Fransentechnik zu der jeweiligen textilen Schicht verarbeitet werden.

Als Material für die Kettfäden ist Polyester vorgesehen. Der Abstand benachbarter Kettfäden kann im Bereich von etwa 1 bis 10 mm liegen, wobei ein Abstand im Bereich von 3 bis 5 mm bevorzugt ist. Als Material für die Schussfäden werden vorzugsweise solche aus PA6.6 (Polyamid 6.6) verwendet, die sehr gute mechanische Eigenschaften in Bezug auf Steifigkeit und Härte, Abrieb, Festigkeit und Wärmeformbeständigkeit zeigen, mit einer metallischen Schicht, vorzugsweise einer Silberbeschichtung. Die Leitfähigkeit der Schussfäden sollte bei kleiner 500 Ohm/m liegen. Die Schussfäden werden bevorzugt so verarbeitet, dass ein mittlerer Abstand benachbarter Schussfäden, in Richtung des Verlaufs der Kettfäden gesehen, zwischen 0,5 und 1,5 mm beträgt.

In einer weiteren Ausführungsform werden mindestens zwei Arten von Schussfäden eingesetzt, die aus einem zueinander unterschiedlichen elektrisch leitfähigen Material bestehen. Bei einem Textil, bei dem die Schussfäden mäanderförmig zwischen mindestens zwei benachbarten Kettfäden verlaufen, ist vorgesehen, dass sich die Schussfäden unterschiedlicher Leitfähigkeit zwischen benachbarten Kettfäden abwechseln. Es ist auch vorgesehen, dass sich die Schussfäden einer Leitfähigkeit mäanderförmig zwischen bis zu 10, vorzugsweise bis zu 5, benachbarten und im Wesentlichen parallel zueinander laufenden Kettfäden erstrecken, bevor Schussfäden der anderen Leitfähigkeit zwischen sich daran anschließenden Kettfäden verlaufen. Entsprechend kann ein Schussfaden mehrere Kettfäden überspannen. Die Mäander des jeweiligen Schussfadens können, in Richtung des Verlaufs der Kettfäden gesehen, einen mittleren Abstand von 0,5 bis 1,5 mm aufweisen. Ein Bereich von Schussfäden mit diesen Abständen kann sich mit einem benachbarten Bereich abwechseln, bei dem die Mäander der Schussfäden einen mittleren Abstand von 1,5 bis 10 mm aufweisen. Wenn sich die Abstände der Schussfäden benachbarter Bereiche in dieser Form abwechseln, können die Materialien der Schussfäden der jeweiligen Bereiche auch gleich sein. Über die unterschiedlichen Materialien der Schussfäden und/oder über die unterschiedlichen Abstände der Mäander der Schussfäden und/oder über die Anzahl der Kettfäden, über die sich die jeweiligen Schussfäden erstrecken, kann der Widerstandswert einzelner Flächenbereiche des leitfähigen Textils eingestellt werden.

In einer weiteren Ausführungsform weisen die Schussfäden metallisierte Kunststofffasern auf.

In einer weiteren Ausführungsform weisen die Schussfäden Drähte aus Metall oder aus einer Metalllegierung auf.

Als Material der Metallfolie wird vorzugsweise Kupfer vorgesehen; die Dicke der Metallfolie sollte im Bereich von 10 bis 200 µm, bevorzugt im Bereich von 10 bis 100 µm, liegen. In einer besonders bevorzugten Ausführungsform kann/können die Sensorschicht und/oder die Abschirmschicht aus einer Metallfolie bestehen, die so durch Schnitte strukturiert ist, dass sie in zumindest einer Richtung ihrer Fläche dehnbar ist. Auch eine solche Metallfolie sollte eine Dicke im Bereich von 10 bis 200 µm haben mit einer bevorzugten Dicke von 10 bis 100 µm. Diese Dehnbarkeit kann bei einer in Bezug auf Material und Dicke geeigneten Metallfolie auch dadurch erreicht werden, dass sie eine geprägte Struktur, mit Prägungen in einer Richtung senkrecht zu der Grundfläche der Metallfolie, die sich für eine Dehnung der Folie zu der Grundfläche der Metallfolie abflachen, besitzt. Die Dicke solcher geprägten Metallfolien liegt ebenfalls im Bereich von 10 bis 200 µm bzw. von 10 bis 100 µm. Eine Strukturierung der Metallfolie kann auch durch eine Ätzung erfolgen, indem die vorstehend erwähnten Schnitte in dem Material der Metallfolie geätzt werden.

Um die jeweiligen Schichten in ihrer Positionierung zueinander zu fixieren, kann ein Klebematerial eingesetzt werden, das zumindest punktweise die Schichten verbindet. Als Klebematerial zum Fixieren der Schichten in ihrer Position kann eine beidseitig klebende Schicht, beispielsweise ein doppelseitiges Klebeband, verwendet werden. Weiterhin ist auch ein Klebevlies oder ein Schmelzkleber vorgesehen.

Als Material für die Decklage können ein Polyurethan-(PU)-Schaum, ein Terpolymer Elastomer, ein Vlies oder eine Folie eingesetzt werden. Das verwendete Material wird auf die Haptik, die an dem Lenkrad erreicht werden soll, abgestimmt. Eine Decklage auf einem Polyurethan-(PU)-Schaum ist dann bevorzugt, wenn eine weiche Haptik gewünscht ist. Ein terpolymeres Elastomer (Gummi) ist unter anderem ein EPDM (Ethylen-Propylen-Dien-Kautschuk). EPDM sowie EPM (Ethylen-Propylen-Kautschuk) hat den Vorteil, dass es wasserresistent und hoch flexibel, auch noch bei Kälte, ist, während mit einem Vlies-Material als Decklage eine härtere Haptik erreicht wird. Mit einer Folie kann ein Durchtritt von Feuchtigkeit durch die Decklage verhindert oder auch nur eingestellt werden.

Als Material für die Isolationsschicht ist ein terpolymeres Elastomer (Gummi), ein Vlies, eine Folie, ein Moosgummi oder ein PU-Schaum, bevorzugt ein geschlossen poriger Schaum, vorgesehen. Es ist in jedem Fall darauf zu achten, dass die Isolationsschicht in erster Linie elektrisch isolieren soll. Falls für die Deckschicht ein Folienmaterial eingesetzt wird, sollte dieses eine Dicke von 10 µm bis 200 µm, bevorzugt von 20 µm bis 50 µm, aufweisen.

Für eine zusätzliche Fixierung und für eine Optimierung der Leitfähigkeit kann zwischen der Isolationsschicht und der Sensorschicht und/oder zwischen der Isolationsschicht und der Abschirmschicht mindestens ein elektrisch leitfähiges Klebeband positioniert werden. Mit dieser Maßnahme wird auch erreicht, dass eine größere Fläche der jeweiligen Schicht zusätzlich durch die Abdeckung überbrückt wird. Die Leitfähigkeit der entsprechenden Klebeschicht sollte dabei bevorzugt im Bereich von kleiner 50kOhm/square liegen.

Um bezüglich der Abschirmschicht und der Sensorschicht ein gleiches Materialverhalten, insbesondere ein gleiches Dehnverhalten, zu erreichen, wird für die Abschirmschicht und die Sensorschicht ein im Wesentlichen identischer Aufbau, der auch die Struktur dieser Schichten betrifft, gewählt.

Um eine noch gleichmäßigere Leitfähigkeit der Abschirmschicht und/oder der Sensorschicht zu erlangen, können diese zusätzlich leitfähiges Graphit oder Metallpartikel aufweisen, das bzw. die in den Schichten eingelagert werden kann/können.

Falls der Lenkradkranz des Lenkrads beheizt werden soll und folglich in die Lenkradummantelung eine zusätzliche Heizschicht integriert wird, wird, in Richtung des Lenkradkerns gesehen, eine weitere Isolationsschicht angeordnet, die die Heizschicht von den weiteren Schichten, d. h. der Abschirmschicht und der Sensorschicht, trennt.

Weitere Einzelheiten und Merkmale der Erfindung ergeben sich aus der nachfolgenden Beschreibung von Ausführungsbeispielen anhand der Zeichnung. In der Zeichnung zeigt
- Figur 1: einen Schichtaufbau für eine Lenkradummantelung eines Lenkrads in einer schematischen, perspektivischen Explosionsansicht,
- Figur 2: den Aufbau eines Lenkrads,
- Figur 3: einen Aufbau einer Leiterstruktur der Sensorschicht oder der Abschirmschicht,
- Figuren 4a bis 4d: verschiedene Ausschnitte unterschiedlich strukturierter Metallfolien, die für die Abschirmschicht oder Sensorschicht eingesetzt werden können,
- Figur 5: einen Teil einer Sensorschicht oder Abschirmschicht, wie diejenige, die auch in Figur 3 gezeigt ist, mit einem Abschnitt einer Metallfolie, über die die Sensorschicht oder die Abschirmschicht kontaktiert wird und mit der der Leiter eines Anschlusskabels verbunden ist, und
- Figur 6: eine Ansicht entsprechend der Figur 5, bei der eine Lasche vorgesehen ist.

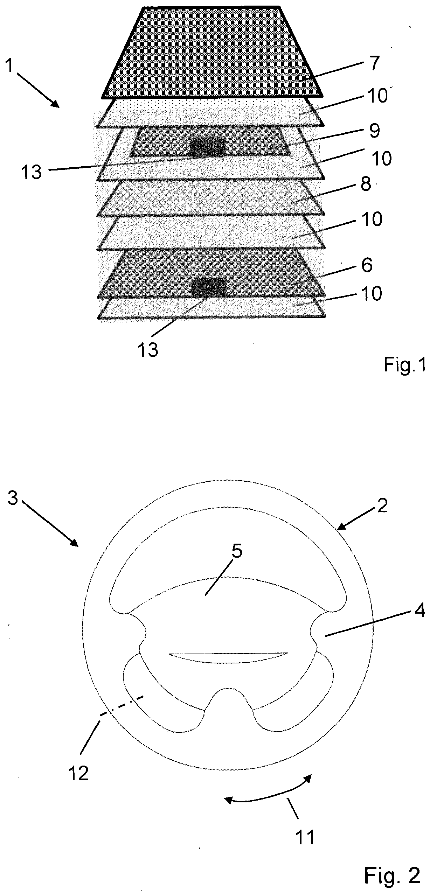

Die Lenkradummantelung 1, wie sie in Figur 1 dargestellt ist, besitzt einen mehrschichtigen Aufbau. Diese Lenkradummantelung 1 wird auf einem Lenkradkranz 2 eines Lenkrads 3, das in Figur 2 gezeigt ist, angeordnet. Ein solcher Lenkradkranz 2 ist über Lenkradspeichen 4 an einer Lenkradnabe im Bereich eines zentralen Pralltopfs 5 gehalten.

Die Lenkradummantelung 1 umfasst eine untere Abschirmschicht 6, die zu einem Lenkradkern des Lenkradkranzes 2 hin orientiert ist, und eine obere Decklage 7, die zu einem nicht näher dargestellten Lenkradbezug hin weist.

Zwischen der Abschirmschicht 6 und der Decklage 7 der Lenkradummantelung 1 befindet sich, von der Abschirmschicht 6 in Richtung der Decklage 7 und damit in Richtung des nicht dargestellten Lenkradbezugs gesehen, eine Isolationsschicht 8 und eine Sensorschicht 9. Sowohl zwischen der Abschirmschicht 6 und der Isolationsschicht 8 als auch zwischen der Isolationsschicht 8 und der Sensorschicht 9 und der Sensorschicht 9 und der Decklage 7 ist jeweils eine Klebeschicht 10 angeordnet, für die vorzugsweise eine doppelseitig klebende Materiallage, vergleichbar mit einem doppelseitigen Klebeband, eingesetzt.

Anhand der Figur 1 ist erkennbar, dass die Sensorschicht 9 eine flächenmäßige Größe besitzt, die geringer ist als die Fläche der Abschirmschicht 6, so dass die Abschirmschicht 6, in Projektion auf die Sensorschicht 9 gesehen, diese Sensorschicht 9 so überdeckt, dass an allen vier Seiten, zumindest jedoch an drei Seiten bzw. zwei Seiten, ein Randbereich der Abschirmschicht 6 verbleibt. Dieser verbleibende Rand ist auch deutlich daran zu erkennen, dass die Klebeschicht 10, die zwischen der Isolationsschicht 8 und der Sensorschicht 9 eingefügt ist und die in ihrer Größe der Größe der Isolationsschicht 8 und der Größe der Abschirmschicht 6 entspricht, einen Kleberand hat, der nicht durch die Sensorschicht 9 bedeckt ist.

Grundsätzlich sind die Flächenabmessungen der einzelnen Schichten 6, 7, 8 und 10 so gewählt, dass sie im Wesentlichen deckungsgleich sind, während nur die Sensorschicht 9 in ihren Abmessungen geringer ist. Das bedeutet, dass die einzelnen Schichten 6, 7, 8 und 10 in ihrer Abwicklung eine Umfangslänge und eine Querschnittsbreite aufweisen derart, dass sich diese Schichten zumindest teilweise in Projektion aufeinander überdecken. Die Umfangslänge der Schichten ergibt sich aus dem Außenumfang des Lenkradkranzes 2 des Lenkrads 3 in Figur 2, die mit dem Umfangspfeil 11 bezeichnet ist, während die Querschnittsbreite dem Umfang des Querschnitts des Lenkradkranzes 2, in Figur 2 mit dem Bezugszeichen 12, entspricht.

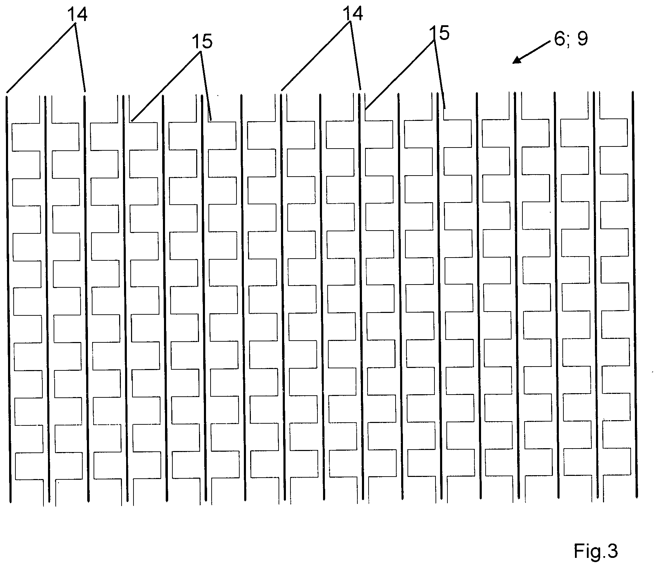

Die Abschirmschicht 6 und/oder die Sensorschicht 9 ist/sind aus einer Leiterstruktur aufgebaut, die beispielsweise in Figur 3 dargestellt ist. Sie bestehen vorzugsweise im Wesentlichen aus einem leitfähigen Gewirke. Als Material für die Decklage 7 wird eine dünne Lage aus einem PU-Schaum (Polyurethan-Schaum), einem Vlies mit einer hohen Stauchhärte oder einer Folie. Die Decklage 7 soll unter anderem verhindern, dass sich Teile der darunterliegenden Schichten durch einen Lenkradbezug abzeichnen.

Für die Isolationsschicht 8 wird eine PU-Schaummatte (Polyurethan-Schaummatte) verwendet, die die Abschirmschicht 6 und die Sensorschicht 9 ausreichend elektrisch gegeneinander isoliert. Als Isolationsschicht 8 kann auch eine Folie oder ein Vlies, beispielsweise entsprechend dem Material der Decklage 7, verwendet werden. Bevorzugt ist ein Aufbau, bei dem die Decklage 7 und die Isolationsschicht 8 in Bezug auf das verwendete Material identisch sind; gerade mit einem solchen Aufbau kann die Decklage 7 etwas dicker sein als die Isolationsschicht 8, wobei dann eine Decklage 7 doppelt so dick wie die Isolationsschicht 8 bevorzugt ist.

In dem gezeigten Schichtaufbau der Lenkradummantelung 1 der Figur 1 ist sowohl an der Abschirmschicht 6 als auch an der Sensorschicht 9 ein Anschlussbereich 13 angedeutet, im Bereich dessen jeweils ein Anschlussleiter eines Anschlusskabels elektrisch mit der jeweiligen Leiterstruktur verbunden wird. Dieser Anschlussbereich 13 liegt jeweils am Rand der jeweiligen Schicht 6 und 9.

Die Anschlussbereiche 13 der jeweiligen Schichten 6 und 9 können in Projektion aufeinander gesehen seitlich versetzt angeordnet sein, so dass zum einen die Dicke des Gesamtaufbaus bei Anschluss eines Anschlusskabels nicht wesentlich zunimmt und zum anderen eine einfachere Montage der jeweiligen Anschlusskabel möglich ist.

Sollte eine versetzte Positionierung der Anschlussbereiche 13 der jeweiligen Schichten 6 und 9, in Projektion aufeinander gesehen, aus Platzgründen nicht möglich sein, dann ist eine Anordnung der Anschlussbereiche 13 der jeweiligen Schichten 6 und 9, in Projektion aufeinander gesehen, auch übereinander möglich, wie dies die Figur 1 zeigt.

Die Figur 3 zeigt einen Aufbau einer Leiterstruktur der Sensorschicht 9 oder der Abschirmschicht 6 mit im Wesentlichen parallel zueinander verlaufenden Kettfäden 14 aus einem nicht leitenden Material, zwischen denen elektrisch leitende Schussfäden 15 verlaufen. Die Schussfäden 15, die zwischen zwei Kettfäden 14 verlaufen, stehen mit den Schussfäden 15 auf der anderen Seite des jeweiligen Kettfadens 14 in Kontakt bzw. sind so in der Schicht verarbeitet, dass sie elektrisch miteinander verbunden sind. Als Material für die leitenden Schussfäden 15 kann ein versilbertes Garn, d. h. ein solches mit einer Oberflächenbeschichtung aus Silber, eingesetzt werden. Der Widerstand des Garns für die leitenden Schussfäden 15 liegt bevorzugt zwischen 500 Ohm/m und 1000 Ohm/m, wobei nach Möglichkeit Fäden mit den kleineren Werten zu verwenden sind.

Die Kettfäden 14 und die Schussfäden 15 werden in einer Franse-Bindung verarbeitet. Auch ist vorgesehen, die Kettfäden 14 und die Schussfäden 15 in einer Trikot-Bindung zu verarbeiten. Mit beiden Techniken kann ein Verlauf der Kettfäden 14 und der Schussfäden 15 erreicht werden, der schematisch in Figur 3 dargestellt ist.

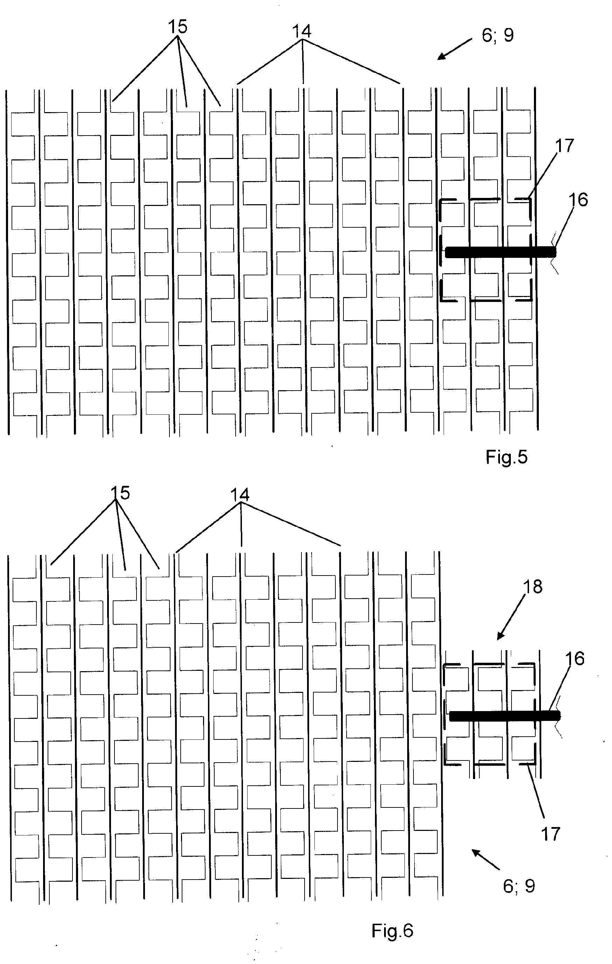

Die Figuren 5 und 6 zeigen einen Ausschnitt einer Leiterstruktur vergleichbar mit derjenigen, die in Figur 3 dargestellt ist. Auch bei dieser Leiterstruktur können die einzelnen Leiter Kettfäden 14 und Schussfäden 15 darstellen. Allerdings kann die Leiterstruktur auch einem anderen Aufbau der Abschirmschicht 6 und der Sensorschicht 9 zugeordnet werden, da die Figuren 5 und 6 dazu dienen, den Anschluss der Schicht aus der leitenden Struktur mit einem Anschlussleiter 16 eines Anschlusskabels zu verbinden.

Gemäß Figur 5 wird der Anschlussleiter 16 so mit der Leiterstruktur verbunden, dass er mehrere Leiter überdeckt, beispielsweise einen Bereich, der sich über mindestens drei Kettfäden 14 erstreckt, wenn die Leiterstruktur der Figur 5 sowohl Kettfäden 14 als auch dazwischen verlaufenden Schussfäden 15 zugeordnet wird. Der Anschlussleiter 16 verläuft vorzugsweise so, dass er im Wesentlichen orthogonal zu dem Verlauf der Kettfäden 14 angeordnet ist. Dadurch steht er mit den Schussfäden 15, die zwischen diesen Kettfäden 14 verlaufen, in elektrischer Verbindung. Zusätzlich ist in einer Ausführungsform in dem Anschlussbereich, wie er vorstehend beschrieben ist, eine Metallfolie auf die Leiterstruktur aufgebracht, die durch ein Rechteck in unterbrochener Linie 17 angedeutet ist. Diese dem Rechteck zugeordnete Metallfolie 17 stellt einen größeren Kontaktierungsbereich der elektrisch leitenden Strukturen der Abschirmschicht 6 oder der Sensorschicht 9 sicher und verbindet diesen Bereich mit dem Anschlussleiter 16. In einer Ausführungsform wird der Anschlussleiter 16 auf der Außenseite der Metallfolie 17, d. h. auf derjenigen Seite, die der Leiterstruktur abgewandt ist, befestigt und mit dieser elektrisch verbunden. Der Anschlussleiter 16 kann aber auch zwischen der Metallfolie 17 und der Leiterstruktur zwischengefügt werden, insbesondere dann, wenn der Anschlussleiter 16 als dünne, flache Leiterbahn ausgeführt wird; diese Leiterbahn kann aus einer Kupferfolie bestehen, aus der auch die Metallfolie 17 aufgebaut werden kann. Eine solche Metallfolie 17 kann zusätzlich mit einer Silberschicht beschichtet, beispielsweise bedampft, werden.

Im Gegensatz zu dem Aufbau der Figur 5 ist der Anschluss mit dem Anschlussleiter 16 an einer Lasche 18 vorgenommen, die aus einem laschenförmigen Abschnitt der Abschirmschicht 6 oder der Sensorschicht 9 geformt ist. Folglich besitzt diese Lasche 18 vorzugsweise eine Leiterstruktur oder einen Materialaufbau entsprechen der weiteren Fläche der jeweiligen Schicht 6 oder 9. Auch kann diese Lasche 18 durch eine Metallfolie 17 entsprechend der Ausführungsform der Figur 5 abgedeckt werden, mit den Vorteilen, die vorstehend anhand der Figur 5 beschrieben sind. Dies bezieht sich auch auf die Größe der Metallfolie 17 und damit auch auf die Größe der Lasche 18. Allerdings kann die Metallfolie 17 auch noch einen Teil des Rands der Hauptfläche der jeweiligen Schicht und damit der Leiterstruktur überdecken, so dass sie der Lasche 18 und der Verbindung der Lasche 18 mit der weiteren Leiterstruktur der Abschirmschicht 6 und Sensorschicht 9 eine zusätzliche Festigkeit verleiht.

Zusätzlich zu der Metallfolie 17, gegebenenfalls aber auch als Alternative zu der Metallfolie 17, kann in einem Bereich, der beispielsweise der unterbrochenen Linie 17 in den Figuren 5 und 6 entspricht, ein leitfähiges Klebemittel aufgebracht werden, um mehrere Leiter der leitfähigen Leiterstruktur zusätzlich untereinander zu verbinden und eine noch größere Kontaktfläche mit der Metallfolie 17 zu erhalten. Der Anschlussleiter 16 kann auch über eine Abdeckung aus einem Vlies oder einem Heißkleber zusätzlich an der Matte gesichert werden. Auch ist vorgesehen, den Anschlussleiter 16 im Bereich der Anschlussfläche (unterbrochene Linie 17 in Figur 5 oder, in Figur 6) in einer oder mehreren Schleifen zu verlegen und zu fixieren, um zusätzliche Zugentlastung der Kontaktbereiche zu erzielen.

In weiteren Ausführungsformen wird die Zuleitung und der Anschlussleiter 16 im Anschlussbereich verlötet, verschweißt oder bevorzugt mit einer Crimp-Verbindung befestigt. Für den Anschlussleiter 16 der Abschirmschicht 6 und den Anschlussleiter 16 der Sensorschicht 9 sollte ein Koaxialkabel verwendet werden, um Störungen zu vermeiden.

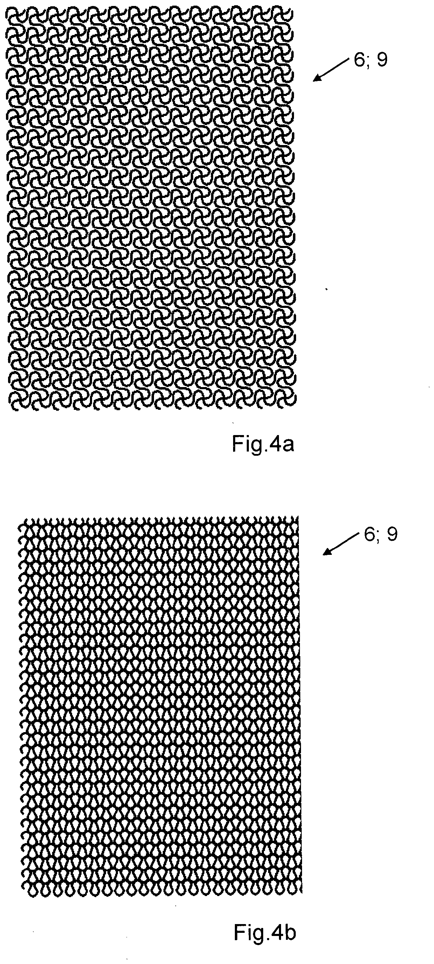

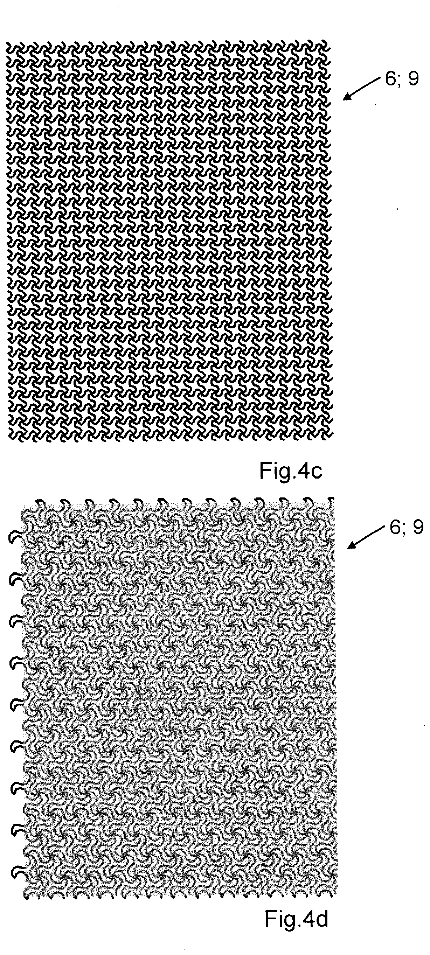

Die Figuren 4a bis 4d zeigen verschiedene Ausschnitte unterschiedlich strukturierter Metallfolien, die für die Abschirmschicht eingesetzt werden können. Diese Metallfolien besitzen Stanzlinien in Form von Mäandern, sternförmigen Strahlen, und dergleichen, insbesondere in Form von griechischen Mäandern oder griechischen Doppelmäandern, so dass zusammenhängende und damit untereinander verbundene Metallstrukturen verbleiben. Solche Metallfolien zeigen ein Dehnverhalten und damit eine Nachgiebigkeit, so dass sie sich den Gegebenheiten am Lenkrad 2 gut anpassen.

## Patentansprüche

1. Lenkradummantelung (1) mit einem mehrschichtigen Aufbau, der in der Abwicklung eine Umfangslänge und eine Querschnittsbreite aufweist und dessen Schichten sich zumindest teilweise in Projektion aufeinander überdecken, mit einer unteren elektrisch leitfähigen Abschirmschicht (6) und mit einer oberen Decklage (7), zwischen denen, von der Abschirmschicht (6) ausgehend, eine Isolationsschicht (8) und mindestens eine elektrisch leitfähige Sensorschicht (9) angeordnet sind, wobei die Abschirmschicht (6) und/oder die Sensorschicht (9) eine Leiterstruktur mit in Umfangslänge und Querschnittsbreite verlaufenden Leitern umfasst und wobei die Abschirmschicht (6) und die Sensorschicht (9) mit Anschlussleitern (16) eines Anschlusskabels elektrisch verbunden sind, **dadurch gekennzeichnet, dass** die elektrische Verbindung des jeweiligen Anschlussleiters (16) des Anschlusskabels mit der Abschirmschicht (6) und/oder der Sensorschicht (9) über jeweils eine Metallfolie (17) gebildet ist.

2. Lenkradummantelung nach Anspruch 1, **dadurch gekennzeichnet, dass** die Abschirmschicht (6) und/oder die Sensorschicht (9) eine gewirkte Struktur mit nicht leitenden, maschenbildenden Kettfäden (14) und mit leitenden Schussfäden (15) aufweist.

3. Lenkradummantelung nach Anspruch 1, **dadurch gekennzeichnet, dass** die Metallfolie (17) mehrere Leiter (15) der jeweiligen Leiterstruktur der Abschirmschicht (6) oder der Sensorschicht (9) überdeckt und dass die Metallfolie (17) mittels elektrisch leitfähigem Klebemittel mit den Leitern (15) der jeweiligen Leiterstruktur verbunden ist.

4. Lenkradummantelung nach einem der Ansprüche 1 bis 3, **dadurch gekennzeichnet, dass** die Abschirmschicht (6) und/oder Sensorschicht (9) aus einem leitfähigen Textil gebildet ist/sind.

5. Lenkradummantelung nach Anspruch 4, **dadurch gekennzeichnet, dass** das leitfähige Textil metallisierte, textile Fasern aufweist.

6. Lenkradummantelung nach einem der Ansprüche 1 bis 5, **dadurch gekennzeichnet, dass** die Sensorschicht (9) und die Abschirmschicht (6) mit der dazwischen liegenden Isolationsschicht (8) einen Kondensator mit einer Kapazität von mindestens 100 pF bilden.

7. Lenkradummantelung nach einem der Ansprüche 1 bis 6, **dadurch gekennzeichnet, dass** die Sensorschicht (9) in ihrer Fläche kleiner ist als die Abschirmschicht (6).

8. Lenkradummantelung nach einem der Ansprüche 2 bis 7, **dadurch gekennzeichnet, dass** sich Schussfäden (15) des textilen Materials zwischen Kettfäden (14) des textilen Materials erstrecken, wobei jeder Schussfaden (15) mit mindestens dem nächsten benachbarten Schussfaden (15) in einer elektrischen Verbindung steht.

9. Lenkradummantelung nach einem der Ansprüche 2 bis 8, **dadurch gekennzeichnet, dass** zwischen benachbarten, zueinander beabstandeten Kettfäden (14) die leitfähigen Schussfäden (15) verlaufen.

10. Lenkradummantelung nach einem der Ansprüche 1 bis 9, **dadurch gekennzeichnet, dass** zumindest ein Teil der jeweiligen Schichten (6, 7, 8, 9) in ihrer Positionierung zueinander über ein Klebematerial fixiert ist.

11. Lenkradummantelung nach einem der Ansprüche 1 bis 10, **dadurch gekennzeichnet, dass** die Decklage (7) aus einem PU-Schaum, einem Terpolymer Elastomer, einem Vlies oder einer Folie gebildet ist.

12. Lenkradummantelung nach einem der Ansprüche 1 bis 11, **dadurch gekennzeichnet, dass** die Isolationsschicht (8) aus einem Terpolymer Elastomer, einem Vlies, einer Folie, einem Moosgummi oder einem PU-Schaum, bevorzugt einer geschlossenen Schicht, gebildet ist.

13. Lenkradummantelung nach einem der Ansprüche 1 bis 12, **dadurch gekennzeichnet, dass** unter der Abschirmschicht (6), in Richtung eines Lenkradkerns gesehen, eine weitere Isolationsschicht angeordnet ist.

## Claims

1. A steering wheel cover (1) with a multilayer structure which in the unwound state has a circumferential length and a cross-sectional width and whose layers cover each other at least partially in projection, with a lower electrically conductive shielding layer (6) and with an upper cover layer (7), between which are arranged, starting from the shielding layer (6), an insulation layer (8) and at least one electrically conductive sensor layer (9), wherein at least one of the shielding layer (6) and the sensor layer (9) comprises a conductor structure with conductors extending in circumferential length and cross-sectional width, and wherein the shielding layer (6) and the sensor layer (9) are electrically connected to connecting conductors (16) of a connecting cable, **characterized in that** the electrical connection of the respective connecting conductors (16) of the connecting cable with at least one of the shielding layer (6) and the sensor layer (9) is formed by a respective metal foil (17).

2. A steering wheel cover according to claim 1, **characterized in that** at least one of the shielding layer (6) and the sensor layer (9) has a knitted structure with non-conductive, stitch-forming warp threads (14) and conductive weft threads (15).

3. A steering wheel cover according to claim 1, **characterized in that** the metal foil (17) covers multiple conductors (15) of the respective conductor structure of the shielding layer (6) or the sensor layer (9), and that the metal foil (17) is connected to the conductors (15) of the respective conductor structure by means of an electrically conductive adhesive.

4. A steering wheel cover according to one of claims 1 to 3, **characterized in that** at least one of the shielding layer (6) and the sensor layer (9) is formed of a conductive textile.

5. A steering wheel cover according to claim 4, **characterized in that** the conductive textile comprises metallized textile fibers.

6. A steering wheel cover according to one of claims 1 to 5, **characterized in that** the sensor layer (9) and the shielding layer (6) form a capacitor with a capacitance of at least 100 pF together with the insulation layer (8) therebetween.

7. A steering wheel cover according to one of claims 1 to 6, **characterized in that** the sensor layer (9) has a smaller area than does the shielding layer (6).

8. A steering wheel cover according to one of claims 2 to 7, **characterized in that** weft threads (15) of the textile material extend between warp threads (14) of the textile material, wherein each weft thread (15) is connected electrically to at least the nearest adjacent weft thread (15).

9. A steering wheel cover according to one of claims 2 to 8, **characterized in that** the conductive weft threads (15) extend between adjacent spaced warp threads (14).

10. A steering wheel cover according to one of claims 1 to 9, **characterized in that** at least a portion of the respective layers (6, 7, 8, 9) is secured via an adhesive material in their positions with respect to each other.

11. A steering wheel cover according to one of claims 1 to 10, **characterized in that** the cover layer (7) is made of PU foam, an elastomeric terpolymer, a nonwoven or a foil.

12. A steering wheel cover according to one of claims 1 to 11, **characterized in that** the insulation layer (8) is made of an elastomeric terpolymer, a nonwoven, a foil, a foamed rubber or a PU foam, preferably a closed layer.

13. A steering wheel cover according to one of claims 1 to 12, **characterized in that** an additional insulation layer is arranged underneath the shielding layer (6), viewed in a direction of a steering wheel core.

## Revendications

1. Enveloppe de recouvrement de volant de direction (1) comprenant un agencement multicouche, qui, en développement, présente une longueur périphérique et une largeur de section transversale, et dont les couches se recouvrent au moins partiellement en projection les unes sur les autres, l'agencement comportant une couche de blindage (6) inférieure, électriquement conductrice, et une couche de recouvrement (7) supérieure, entre lesquelles, à partir de la couche de blindage (6), sont agencées une couche d'isolation (8) et au moins une couche de détection (9) électriquement conductrice, la couche de blindage (6) et/ou la couche de détection (9) comprenant une structure conductrice avec des conducteurs, qui s'étendent dans la direction de la longueur périphérique et de la largeur de section transversale, et la couche de blindage (6) et la couche de détection (9) étant reliées électriquement à des conducteurs de branchement (16) d'un câble de branchement,
**caractérisée en ce que** la liaison électrique du conducteur de branchement (16) respectif du câble de branchement avec la couche de blindage (6) et/ou la couche de détection (9), est réalisée respectivement par l'intermédiaire d'une feuille de métal (17).

2. Enveloppe de recouvrement de volant de direction selon la revendication 1, **caractérisée en ce que** la couche de blindage (6) et/ou la couche de détection (9) présente une structure tricotée avec des fils de chaine (14) non conducteurs formant des mailles et avec des fils de trame (15) conducteurs.

3. Enveloppe de recouvrement de volant de direction selon la revendication 1, **caractérisée en ce que** la feuille de métal (17) recouvre plusieurs conducteurs (15) de la structure conductrice respective de la couche de blindage (6) ou de la couche de détection (9), et **en ce que** la feuille de métal (17) est reliée, au moyen d'une colle électriquement conductrice, aux conducteurs (15) de la structure conductrice respective.

4. Enveloppe de recouvrement de volant de direction selon l'une des revendications 1 à 3, **caractérisée en ce que** la couche de blindage (6) et/ou la couche de détection (9) est/sont constituée(s) par un textile conducteur.

5. Enveloppe de recouvrement de volant de direction selon la revendication 4, **caractérisée en ce que** le textile conducteur comprend des fibres textiles métallisées.

6. Enveloppe de recouvrement de volant de direction selon l'une des revendications 1 à 5, **caractérisée en ce que** la couche de détection (9) et la couche de blindage (6) forment, avec la couche d'isolation (8) située entre elles, un condensateur d'une capacité d'au moins 100 pF.

7. Enveloppe de recouvrement de volant de direction selon l'une des revendications 1 à 6, **caractérisée en ce que** la couche de détection (9) est plus petite en surface, que la couche de blindage (6).

8. Enveloppe de recouvrement de volant de direction selon l'une des revendications 2 à 7, **caractérisée en ce que** les fils de trame (15) du matériau textile, s'étendent entre des fils de chaine (14) du matériau textile, chaque fil de trame (15) étant en liaison électrique avec au moins le fil de trame (15) voisin, suivant.

9. Enveloppe de recouvrement de volant de direction selon l'une des revendications 2 à 8, **caractérisée en ce qu'**entre des fils de chaine (14) voisins, espacés les uns par rapport aux autres, s'étendent les fils de trame (15) conducteurs.

10. Enveloppe de recouvrement de volant de direction selon l'une des revendications 1 à 9, **caractérisée en ce qu'**au moins une partie des couches (6, 7, 8, 9) respectives, sont fixées quant à leur positionnement réciproque, à l'aide d'une colle.

11. Enveloppe de recouvrement de volant de direction selon l'une des revendications 1 à 10, **caractérisée en ce que** la couche de recouvrement (7) est réalisée en une mousse de PU, un élastomère terpolymère, un non-tissé ou un film.

12. Enveloppe de recouvrement de volant de direction selon l'une des revendications 1 à 11, **caractérisée en ce que** la couche d'isolation (8) est réalisée en un élastomère terpolymère, un non-tissé, un film, un caoutchouc mousse ou une mousse de PU, de préférence une couche fermée.

13. Enveloppe de recouvrement de volant de direction selon l'une des revendications 1 à 12, **caractérisée en ce que** sous la couche de blindage (6) est agencée, en direction de l'âme du volant de direction, une autre couche d'isolation.
